# EUROPEAN PATENT APPLICATION

(11) **EP 2 056 496 A1**
(43) Date of publication of application: **06.05.2009**
(21) Application number: 07291320.5
(22) Date of filing: 02.11.2007
(51) Int. Cl.: H04B 17/00

(54) **Wideband feedback path frequency response calibration method**

(71) Applicant: Alcatel Lucent, 75008 Paris (FR)
(72) Inventor: Heinz Schlesinger, 74395 Mundelsheim (DE); Ferling Dieter, Stuttgart 70199 (DE)
(74) Representative: Richardt, Markus Albert

(57) **Abstract**

The present invention relates to a method for compensating nonlinearities in a radio transmitter feedback path. The method comprises the step of sending at least one test signal over the feedback path. Thereafter, the frequency response of the feedback path is determined by measuring the feedback test signals. Finally, the frequency response is compensated.

## Description

The present invention relates to a method for compensating nonlinearities in a radio transmitter feedback path and a radio transmitter having a feedback path.

The present invention relates to the field of radio transmitter, in particular radio transmitters, which are used in wireless telecommunication networks. In the area of wireless computer networking, a base station is a radio receiver/transmitter that serves as the hub of the local wireless network, and may also be the gateway between a wired network and the wireless network. A Base Transceiver Station is the equipment which facilitates the wireless communication between user equipments and the network. User equipments are devices like mobile phones (handsets), computers having wireless connectivity. The network can be that of any of the wireless communication technologies like GSM or UMTS.

W-CDMA (Wideband Code Division Multiple Access) is a type of 3G cellular network. W-CDMA is the higher speed transmission protocol used in the UMTS system, a third generation follow-on to the 2G GSM networks deployed worldwide. W-CDMA is a wideband spread-spectrum mobile air interface that utilizes the direct sequence Code Division Multiple Access signaling method to achieve higher speeds and support more users compared to the implementation of time division multiplexing (TDMA) used by 2G GSM networks.

Wideband is a relative term used to describe a wide range of frequencies in a spectrum. A wideband communication channel is a channel having a large bandwidth. Bandwidth is the difference between the upper and lower cutoff frequencies of a communication channel or a signal spectrum. It is typically measured in hertz. The cutoff frequency is the frequency either above which or below which the power output of a circuit, such as an amplifier, transmitter or electronic filter is 1 / 2 the power of the pass band. Since the output power is P proportional to voltage V², the cutoff voltage is equal to V/2^{1/2}. This happens to be close to -3 dB of output reference voltage, and the cutoff frequency is frequently referred to as the -3 dB point.

Hence, 3G cellular networks require a wideband transmitter circuit. The wideband transmitter has two cutoff frequencies and their geometric mean is the center frequency. Therefore, means must be provided, which allow a transmitter to radio frequencies within a large bandwidth. Conventionally, radio frequency transmitters are equipped with feedback circuits in order to provide a linearized broadband output signal.

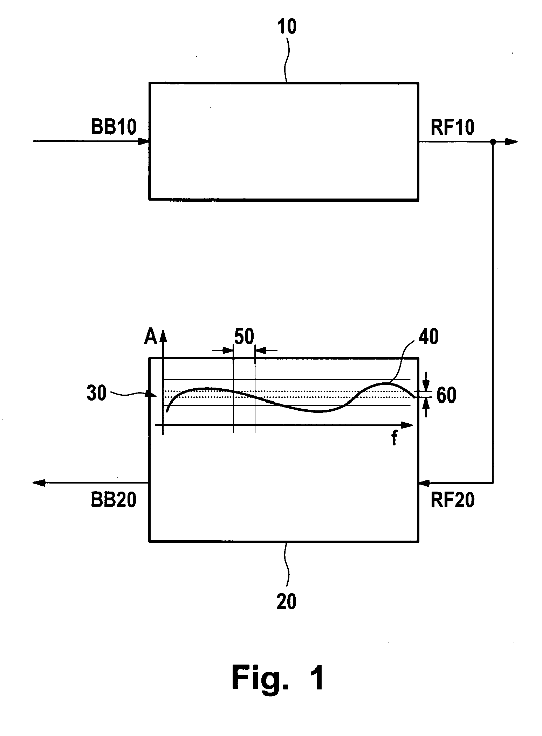

Figure 1 shows schematically the output stage of a conventional narrowband RF transmitter. The output stage comprises an up conversion and amplification means 10. The up conversion means 10 receives a modulated input signal BB10. The frequency band of the input signal is not in the required radio frequency region. Therefore, the signal is up converted into the desired frequency region. This is conventionally done using an electronic mixer. A mixer is a nonlinear circuit or device that accepts as its input two different frequencies and presents at its output the product of the input signals. The resulting frequency band comprises the sum of the frequencies of the input signals, and the difference between the frequencies of the input signals. A band pass-filter is used for selecting one of the output sum or difference frequency. Finally, the RF-Signal is amplified and output to an antenna. Reference sign RF10 identifies the radio frequency output signal fro the up conversion and amplification means.

The conventional narrowband RF transmitter additionally comprises a feedback path. The output radio frequency signal RF10 is redirected to the input of a feedback means 20. The input signal RF20 of the feedback means is identical with the output signal of the up conversion and amplification means. The feedback path down converts the input signal RF20. The down converted signal BB20 is compared with the originally sent signal BB10 in order to determine, whether and how the transmitter distorts the transmitted signal. The input signal to the up conversion and amplification means is predistorted in order to compensate the transmitter distortion.

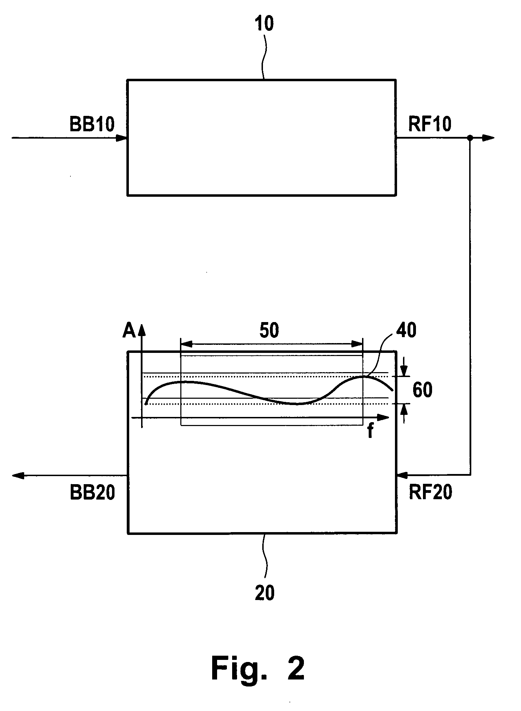

Figure 1 further displays the frequency response of the feedback path. The frequency response is a measure of any system's response at its output to a signal of varying frequency (but constant amplitude) at its input. The transfer function is the mathematical representation of the relation between the input and output of the system. In figure 1, the amplitude A and the frequency of the feedback path 20 is represented in a coordinate system. Graph 40 in the coordinate system 30 is a graphical representation of the frequency response of the feedback path 20. An ideal frequency response would be a flat horizontal curve. However, due to the imperfections of analogue electronic components the actual frequency response deviates from this ideal. However, this deviation is not troubling in narrowband RF transmitter. Reference sign depicts the bandwidth of a narrowband RF transmitter. Reference sign 60 represents the deviation of the frequency response from the ideal flat curve. If the bandwidth is sufficiently narrow, the resulting amplitude variations are also very small, such that the feedback path does not introduce significant errors. However, the same feedback path may introduce unwanted error, if the bandwidth of the RF signal is a wideband signal. Figure 2 represents also the output stage of a conventional RF transmitter. However, in this case a wideband transmitter is used. The up conversion and amplification means 10 I figure 2 up converts and amplifies broadband signals. Otherwise, the reference signs of figures 1 and 2 and represent corresponding electronic components. In particular, the same feedback means 20 having the same graph 40 are shown in figure 2. However, the bandwidth 50 is considerably larger than in the narrowband transmitter of figure 1. Consequently, the resulting frequency response deviation 60 has increased considerably. Thereby, an additional error is introduced to the output signal BB20 from the feedback path. This additional error is part of the output signal form the feedback path 20. Therefore, the comparison of the transmitted signal BB10 with the feedback signal BB20 will misinterpret the feedback distortion as a distortion introduced by the up conversion and transmission means 10. Consequently, predistortion of the signal input to the up conversion and amplification means may actually deteriorate the quality of the output signal BB20.

Therefore, it is object of the present invention, to provide a transmitter and a transmission method, which improves the quality of signal transmission, in particular the quality of signal predistortion.

The present invention is embodied by a radio transmitter for transmitting wideband radio signals. The radio transmitter comprises a feedback path connected to the output of the radio transmitter for recording the output signal. A comparator is provided in order to compare the feedback signal with the output signal intended for transmission. An electronic filter compensates the frequency response of the feedback path by correcting the feedback signal.

Essentially, the output signal from the feedback path is postdistorted in order to compensate the feedback path frequency response before the feedback signal is further utilized. Therefore, the additional error introduced because of the non-linear frequency response of the feedback path is compensated. A comparator, which compares the compensated feedback signal with the intended output signal, may no longer misinterpret the deviations due to the feedback path as a deviation of the output RF signal. Therefore, predistortion based on the feedback path may be performed more precisely. The quality of signal transmission is improved.

Preferably, the transmitter according to the present invention further comprises a test signal generator for transmitting at least one test signal across the feedback path. In addition a measurement device measures the test signal output from the feedback path. A determining device determines the frequency response of the feedback path using the measured test signal. These additional features allow the transmitter to determine the frequency response of the feedback path on its own. Therefore, the frequency response of the feedback path may be periodically determined over time. Any variations of the feedback path frequency response over time due to wear can be detected. The electronic filter can be adjusted to compensate the changed frequency response.

According to a preferred embodiment of the present invention, the Radio transmitter comprises test signal generator, which generates sine waves having a predetermined amplitude, phase and frequency within the bandwidth of the radio transmitter. The feedback path may alter the amplitude and phase of the test signal. The frequency response of the feedback path may be determined by simply comparing the feedback test signal with the input test signal. The changes to the amplitude and phase of the test signal represent the frequency response of the feedback path at the frequency of the sinusoidal test signal. In order to precisely determine the frequency response over the whole bandwidth, plural sinusoidal test signals spanning the whole bandwidth have to be recorded.

Alternatively, the test signal generator is adapted to generate a pulse signal. A pulse is a rapid, transient change in the amplitude of a signal from a baseline value to a higher or lower value, followed by a rapid return to the baseline value. An ideal delta pulse is infinitely short in time while maintaining its area or integral, thus giving an infinitely high peak. An ideal delta pulse has a flat frequency spectrum. The frequency spectrum of a signal is obtained by performing a Fourier transform. Therefore, the spectrum of the feedback pulse signal simply represents the frequency response of the feedback path. The determining device may simply determine the frequency response of the feedback path by Fourier-transforming (FT) or fast-Fourier-transforming (FFT) the feedback pulse signal.

Alternatively, the test signal generator is adapted to generate a sinusoidal wave having a frequency which increases or decreases continually over time. Such a test signal may be referred to as a frequency sweep. The continual increase of the sinusoidal wave has the effect that the whole bandwidth of the transmitter may be spanned by the test signal. A single instead of a multitude of sinusoidal test signals may be used for measuring frequency response of the feedback path across the whole bandwidth of the transmitter.

Last but not least, the test signal may be white noise. White noise is a random signal with a flat power spectrum. In other words, the signal's power spectrum has equal power in any band, at any centre frequency, having a given bandwidth. White noise is considered analogous to white light which contains all frequencies. The flat frequency spectrum facilitates the determination of the frequency response of the feedback path.

Once the frequency response is determined, the electronic filter must be programmed in order to compensate for the frequency response. The electronics filter must have the inverted frequency response of the feedback path. Thereby, the feedback paths frequency response is cancelled by the electronic filter's frequency response. Preferably, electronic filters such as FIR (finite impulse response filter) or IIR (infinite impulse response filter) are chosen. A digital filter is any electronic filter that works by performing digital mathematical operations on an intermediate form of a signal. The main advantage of the digital filter is that it may be programmed to achieve virtually any filtering effect that can be expressed as a mathematical function. According to a preferred embodiment, the measurement device is adapted to digitalize the measured frequency response and store the frequency response in a look-up-table. The filter response is calculated by inverting the measured feedback frequency response.

Preferred embodiments of the present invention are described hereinafter with reference to the accompanied drawings.
- Figure 1: shows a conventional narrowband radio frequency transmitter.
- Figure 2: show a conventional wideband radio frequency transmitter.
- Figure 3: shows a wideband radio frequency transmitter according to a first pre- ferred embodiment of the present invention.
- Figure 4: shows a wideband radio frequency transmitter according to a second preferred embodiment of the present invention.

The transmitter according to the preferred embodiment of the present invention comprises an up conversion and amplification means 10. Means 10 converts an intermediate frequency of an input signal BB10 into a radio frequency of an output signal RF10. Additionally, means 10 amplifies the output signal RF10. A feedback path 20 is provided for recording the output signal RF10.

The feedback path has a frequency response, which is represented in a coordinate system 30. The frequency response is a function f → A(f), wherein f represents the frequency and A represents the complex transfer function of the frequency response. The ideal transfer function is constant in amplitude and in group delay for several frequencies. As a real feedback path has not a constant transfer function, a graph 40 of the frequency response does not represent a flat horizontal line.

A frequency band of the transmitter is represented by reference sign 50. The maximum deviation by the graph 40 from a flat horizontal line is represented by reference sign 60. Due to the wide frequency band and the non-linear frequency response of the feedback path 20, the feedback signal output from the feedback path 20 is considerably distorted.

In addition, the embodiment of the present invention comprises an electronic filter 70. The electronic filter is a digital filter, which uses electronic filter for compensating the frequency response 40 of the feedback path. To this end, the electronic filter has a filter response, which corrects the feedback path frequency response in the way to get an approximately constant amplitude and an approximately constant group delay for several frequencies.

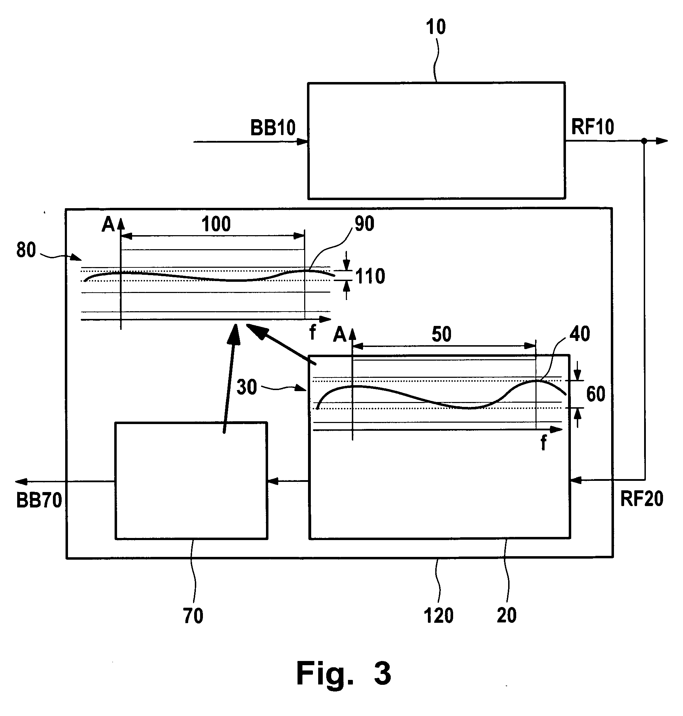

Output signal BB70 of the electronic filter 70 represents the output signal of the electronically filtered feedback path 120. Graph 90 of coordinate system 80 in figure 3 represents the frequency response of the electronically filtered feedback path 120. Reference sign 100 represents the same bandwidth as reference sign 50. The resulting graph is virtually a flat line. The maximum deviation from the flat horizontal line is represented by reference sign 110.

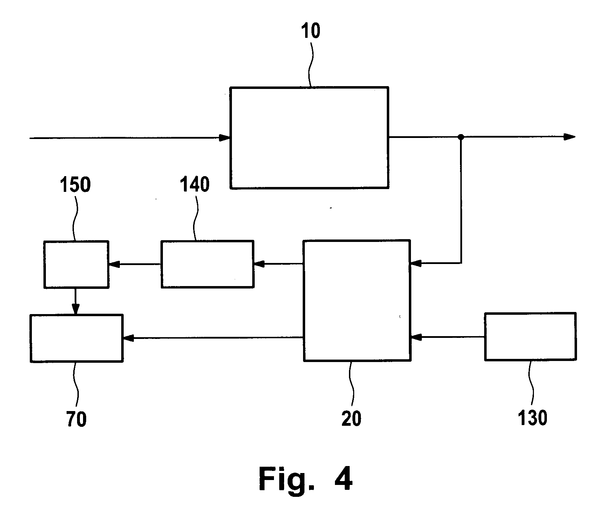

Figure 4 shows a wideband radio frequency transmitter according to a second preferred embodiment of the present invention. Corresponding means are represented by the same reference signs in Figure 3 and 4. The radio transmitter of the second preferred embodiment comprises additionally a test signal generator 130. The test signal generator may generate any kind of suitable test signals, such as sinusoidal waves, sinusoidal sweeps, white noise or pulse waves. These test signals are radio frequency signals, which are directly input to the feedback path 20.

The feedback path 20 outputs the test signal to a measurement device 140. The measurement device records the output signal from the feedback path. Preferably, the measurement device converts the output signal from the feedback path into a digital signal (A/D-converter) and stores the resulting values in a look up table.

A determining device 150 is connected to the measuring device. The determining device uses the digitally recorded output test signal from the feedback path in order to determine the frequency response of the feedback path. Therefore, the determining device may compute the discrete Fourier-transform of the feedback test signal. If the frequency spectrum of the test signal is a flat horizontal curve as in the case of an impulse signal or statistical white noise, then the discrete Fourier-transform provides the frequency response of the feedback path 20.

Finally, the determining device inverts the measured frequency response of the feedback path and outputs the respective filter coefficients to the digital electronic filter 70. The electronic filter 70 is an infinite impulse response filter (IIR). The electronic filter comprises digital signal processor. A digital signal processor (DSP) is a specialized microprocessor designed specifically for digital signal processing, generally in real-time computing.

### List of reference numerals

- 10: up conversion and amplification means;
- 20: feedback path;
- 30: coordinate system for representing the frequency response of the feed- back path;
- 40: A graph representing the frequency response of the feedback path;
- 50: frequency band of the transmitter;
- 60: deviation of the frequency response from a flat horizontal line within the frequency band;
- 70: electronic filter for compensating feedback path frequency response;
- 80: frequency spectrum of the electronically filtered feedback path;
- 90: graph of the frequency spectrum electronically filtered feedback path;
- 100: bandwidth of the transmitter
- 110: deviation of the frequency response from a flat horizontal line within the frequency band
- 120: electronically filtered feedback path
- 130: test signal generator
- 140: measurement device
- 150: determining device

- BB10: input signal to up conversion and amplification means
- BB20: output signal from feedback path
- BB70: electronically filtered feedback signal

- RF10: output signal from up conversion and amplification means
- RF20: input signal to feedback path

## Claims

1. A method for compensating nonlinearities in a radio transmitter feedback path, **characterized by** the steps:
- Sending at least one test signal across the feedback path,
- Measuring the test signal output from the feedback path,
- Determining a frequency response of the feedback path using the measured test signal, and
- Compensating the frequency response of the feedback path by distorting the feedback signals.

2. The method according to claim 1, wherein the test signals represent sinusoidal waves having a predetermined amplitude, phase and frequency within the bandwidth of the radio transmitter.

3. The method according to claims 1, wherein the measured frequency response is stored digitally in a look up table.

4. The method according to claim 1, wherein the feedback signal is digitally distorted such that the frequency response of the feedback path is compensated.

5. A Radio transmitter for transmitting radio signal, comprising
- A feedback path (20) connected to the output of the radio transmitter for recording the output signal,
- **characterized by**
an electronic filter (70) for compensating the frequency response of the feedback path (20) by correcting the feedback signal.

6. The Radio transmitter according to claim 5, comprising a test signal generator (130) for transmitting at least one test signal to the feedback path,
- A measurement device (140) for measuring the test signal output from the feedback path, and
- A determining device (150) for determining the frequency response of the feedback path using the measured test signal.

7. The Radio transmitter according to claim 5, wherein the test signal generator is adapted to generate sine waves having a predetermined amplitude, phase and frequency within the bandwidth of the radio transmitter.

8. The radio transmitter according to claim 5, wherein the measurement device is adapted to digitalize the measured frequency response and store the frequency response in a look-up-table.

9. The radio transmitter according to claims 5, wherein the electronic filter is adapted to digitally distort the feedback signal such that the frequency response of the feedback path is compensated.

10. Communication network for distributing data among a plurality of network nodes,
**characterized in that**
- at least one of the network nodes comprises a radio transmitter according to one of the claims 5 to 9.

## Amended claims

### Amended claims in accordance with Rule 137(2) EPC.

**1.** A method for compensating nonlinearities in a radio transmitter feedback path,
- Sending at least one test signal across the feedback path,
- Measuring the test signal output from the feedback path, **characterized by** the steps:
- Determining a frequency response of the feedback path using the measured test signal, and
- Compensating the frequency response of the feedback path by distorting the feedback signals.

**2.** The method according to claim 1, wherein the test signals represent sinusoidal waves having a predetermined amplitude, phase and frequency within the bandwidth of the radio transmitter.

**3.** The method according to claims 1, wherein the measured frequency response is stored digitally in a look up table.

**4.** The method according to claim 1, wherein the feedback signal is digitally distorted such that the frequency response of the feedback path is compensated.

**5.** A Radio transmitter for transmitting radio signal, comprising
- A feedback path (20) connected to the output of the radio transmitter for recording the output signal,
- a test signal generator (130) for transmitting at least one test signal to the feedback path,
- A measurement device (140) for measuring the test signal output from the feedback path,
- **characterized by**
- A determining device (150) for determining the frequency response of the feedback path using the measured test signal.
- an electronic filter (70) for compensating the frequency response of the feedback path (20) by correcting the feedback signal.

**6.** The Radio transmitter according to claim 5, wherein the test signal generator is adapted to generate sine waves having a predetermined amplitude, phase and frequency within the bandwidth of the radio transmitter.

**7.** The radio transmitter according to claim 5, wherein the measurement device is adapted to digitize the measured frequency response and store the frequency response in a look-up-table.

**8.** The radio transmitter according to claims 5, wherein the electronic filter is adapted to digitally distort the feedback signal such that the frequency response of the feedback path is compensated.

**9.** Communication network for distributing data among a plurality of network nodes,
**characterized in that**
- at least one of the network nodes comprises a radio transmitter according to one of the claims 5 to 8.
